# EUROPÄISCHE PATENTSCHRIFT

(11) **EP 2 795 669 B1**
(45) Veröffentlichungstag und Bekanntmachung des Hinweises auf die Patenterteilung: **17.06.2020**
(21) Anmeldenummer: 11808644.6
(22) Anmeldetag: 22.12.2011
(51) Int. Cl.: H01L 21/67, H01L 21/687

(54) **BIEGSAME SUBSTRATHALTERUNG, VORRICHTUNG UND VERFAHREN ZUM LÖSEN EINES ERSTEN SUBSTRATS**
FLEXIBLE SUBSTRATE HOLDER, DEVICE AND METHOD FOR DETACHING A FIRST SUBSTRATE
SUPPORT DE SUBSTRAT FLEXIBLE, DISPOSITIF ET PROCÉDÉ PERMETTANT DE DÉTACHER UN PREMIER SUBSTRAT

(43) Veröffentlichungstag der Anmeldung: 29.10.2014
(73) Patentinhaber: EV Group E. Thallner GmbH, 4782 St. Florian am Inn (AT)
(72) Erfinder: WIMPLINGER, Markus, A-4910 Ried im Innkreis (AT); BURGGRAF, Jürgen, A-4780 Schärding (AT); MITTENDORFER, Gerald, A-4975 Suben (AT)
(74) Vertreter: Schweiger, Johannes
(86) Internationale Anmeldenummer: PCT/EP2011/073851
(87) Internationale Veröffentlichungsnummer: WO 2013/091714

(56) Entgegenhaltungen:
- EP-A1- 2 398 040
- WO-A1-00/76899
- DE-A1-102008 018 536
- FR-A1- 2 783 970
- US-A- 5 932 048
- US-A1- 2001 014 514
- US-A1- 2004 166 653
- US-A1- 2009 314 430

## Beschreibung

Die Erfindung betrifft ein Verfahren gemäß Patentanspruch 1 und eine Verwendung gemäß Patentanspruch 5.

In der Halbleiterindustrie werden Strukturwafer beziehungsweise Produktwafer häufig temporär auf Trägerwafer beziehungsweise erste Substrate gebondet, um sie handhaben zu können. Nach Prozessierung der Produktwafer sollen diese möglichst einfach, schnell und kostengünstig sowie sauber von dem ersten Substrat entfernt werden. Das am häufigsten eingesetzte Verfahren zum Bonden von Produktwafern auf einem Trägerwafer ist die Aufbringung einer Adhäsionsschicht auf einem der beiden Substrate (oder beiden Substraten) und Kontaktierung unter Druck. Beim Ablösen (Debonding) wird der Trägerwafer nach Reduzierung der Adhäsionskraft des Klebers (Temperatur, UV-Strahlung etc.) vom Produktwafer abgelöst, beispielsweise durch paralleles Verschieben der Wafer gegeneinander. Die Wafer werden dabei durch sogenannte Chucks durch Unterdruck gehalten. Sehr häufig werden Wafer auch durch Fusionbonding (überwiegend Van-der-Waals-Kärfte) und anschließendes Annealing (Erhitzen über Rekristallisationstemperatur) permanent verbunden.

Beim Debonden sind eine Vielzahl kritischer Faktoren zu berücksichtigen und oberste Priorität besteht darin, den brüchigen und auf Grund der Vorbearbeitung sehr teuren Produktwafer möglichst geringem Stress auszusetzen und diesen nicht zu beschädigen. Das Ablösen des ersten Substrats soll auf der anderen Seite kostengünstig und schnell mit geringst möglichem Energieaufwand erfolgen. Bei einer Vielzahl von bekannten Ablöseprozessen ist es erforderlich, insbesondere zur Auflösung der Adhäsionseigenschaften der Adhäsionsschicht zwischen den Wafern, den "Stack" (Stapel) aus Trägerwafer und Strukturwafer/Produktwafer auf eine für den Kleber spezifische Temperatur aufzuheizen.

Der Stand der Technik zeigt gattungsgemäße Substrathalterungen insbesondere in der DE 10 2008 018536 A1, der US 2009/314430 A1, der EP 2 398 040 Alund der US 2001/214514 A1. Druckschrift US 2004/166653 A1 offenbart ein Verfahren zum Trennen von Substraten.

Aufgabe der vorliegenden Erfindung ist es daher, die gattungsgemäßen Vorrichtungen und Verfahren zum Ablösen von ersten Substraten derart weiterzubilden, dass ein schonendes und gleichzeitig deutlich schnelleres Ablösen ermöglicht wird. Gleichzeitig soll der Energieverbrauch reduziert werden.

Diese Aufgabe wird mit den Merkmalen der Patentansprüche 1 und 5 gelöst. Vorteilhafte Weiterbildungen der Erfindung sind in den Unteransprüchen angegeben.

Grundgedanke der vorliegenden Erfindung ist es, eine Substrathalterung zur Halterung des ersten Substrats beim Lösen des ersten Substrats von dem zweiten Substrat so zu konstruieren, dass die Substrathalterung eine Biegung des ersten Substrats zulassend ausgebildet ist. Die Substrathalterung weist erfindungsgemäß eine ausreichende Biegesteifigkeit auf, um eine Lösekraft zum Ablösen des ersten Substrats vom zweiten Substrat zu bewirken, insbesondere durch Abheben, insbesondere ausschließlich, vom Rand des ersten Substrats her. Erfindungsgemäß soll dabei nur eine leichte Durchbiegung, insbesondere < 45° Biegewinkel, vorzugsweise < 40°, noch bevorzugter < 30°, besonders bevorzugt < 20°, mit noch größerem Vorzug < 10°, mit allergrößtem Vorzug < 5°, erfolgen. Die Durchbiegung wird insbesondere durch steuerbare Kraftbeaufschlagung und/oder der Steuerung der Ablösegeschwindigkeit, insbesondere am Umfang, der Substrathalterung gesteuert. Auf diese Weise wird das auch eine gewisse, insbesondere der Substrathalterung ähnliche, Biegesteifigkeit aufweisende erste Substrat und vor allen Dingen das zweite Substrat vor Beschädigung geschützt. Durch die Biegung wirkt der größte Teil der Lösekraft an der wandernden Lösefront, die insbesondere vom Rand des ersten Substrats her in Richtung des Zentrums wandert. Des Weiteren ist die erfindungsgemäße Ausführungsform auch dazu geeignet, Substrate mit einer (relativ) hohen Bondkraft voneinander zu trennen.

Somit ist die Erfindung insbesondere auch beim Lösen von zwei durch Fusionbonding verbundenen Substraten anwendbar, da sowohl das erste als auch das zweite Substrat durch die erfindungsgemäße, insbesondere steuerbare, Biegung beim Lösen schonend behandelt werden.

Kern der Erfindung ist daher eine biegsame Substrathalterung zur Halterung eines ersten Substrats beim Lösen des ersten Substrats von einem zweiten Substrat, wobei Lösemittel zum Ablösen des zweiten Substrats unter Biegung des ersten Substrats an der Substrathalterung vorgesehen sind.

Erfindungsgemäß denkbar sind also auch vollflächige, nicht ringförmige Ausführungen der Substrathalterung, insbesondere aus Polymer mit einer gewissen Elastizität beziehungsweise Biegesteifigkeit. Diese würden zur Fixierung und Aufnahme des ersten Substrats Vakuumdurchgänge aufweisen. Hierbei kann, insbesondere zusätzlich, zur Erhöhung der Haltekraft, eine elektrostatische Fixierung des ersten Substrats an der Substrathalterung vorgesehen sein.

Die Substrathalterung kann auch zumindest teilweise aus Metall, Keramik oder einem Verbundwerkstoff bestehen. Die verwendeten Materialien müssen nur die erfindungsgemäße Funktionalität erlauben.

Als eigenständige Erfindung ist außerdem eine Vorrichtung zum Lösen eines ersten Substrats von einem zweiten Substrat in einer Löserichtung L mit folgenden Merkmalen vorgesehen:
- einer in Löserichtung L biegsamen ersten Substrathalterung zur Halterung des ersten Substrats,
- einer zweiten Substrathalterung zur Halterung des zweiten Substrats und
- Lösemitteln zum, insbesondere hinsichtlich der die Biegung bewirkenden Kraft gesteuerten, Ablösen des ersten Substrats vom zweiten Substrat unter Biegung des ersten Substrats.

Dabei ist es vorteilhaft, wenn die zweite Substrathalterung zur Aufnahme des empfindlicheren, insbesondere dünneren (vorzugsweise der Produktwafer), Substrats verwendet wird.

Die Löserichtung List erfindungsgemäß normal zur Oberfläche des ersten Substrats und/oder zweiten Substrats. Eine Biegeachse der Biegung der Substrathalterung und/oder des von der Substrathalterung aufgenommenen ersten Substrats ist normal zur Löserichtung L. Die Biegeachse liegt insbesondere parallel zur Oberfläche des zweiten Substrats und/oder des ersten Substrats. Es ist erfindungsgemäß denkbar, dass mehrere, insbesondere radialsymmetrische, Lösungsrichtungen entlang des Umfangs der Substrate, vorgesehen sind, so dass mehrere Biegeachsen vorhanden sind. Dieser Fall würde eintreten, wenn die beiden Substrate durch einen Werkzeugeingriff, insbesondere einen Haltering, entlang des Umfangs voneinander getrennt werden würden.

Die erfindungsgemäße Vorrichtung kann in vorteilhafter Ausführung eine Druckkammer umfassen, die mit Überdruck beaufschlagbar ist, um ein mit Unterdruck an der Substrathalterung fixiertes erstes Substrat noch stärker an diesem zu fixieren. Der Druck in der Kammer kann dabei > 1 bar, mit Vorzug > 2 bar, mit noch größerem Vorzug > 5 bar, mit noch größerem Vorzug > 10 bar, insbesondere kleiner 100 bar, sein.

Erfindungsgemäß ist vorgesehen, dass die Substrathalterung zur Aufnahme des ersten Substrats in Löserichtung L elastisch verformbar ist. Durch die Elastizität der Substrathalterung wird es erfindungsgemäß ermöglicht, die Lösekraft jeweils an der wandernden Lösefront zu konzentrieren, obwohl eine, insbesondere steuerbare, Zugkraft nur am Umfang des ersten Substrats angelegt wird.

In einer weiteren vorteilhaften Ausführungsform der Erfindung ist vorgesehen, dass durch die Lösemittel mindestens eine am Umfang der zweiten Substrathalterung zur Aufnahme des zweiten Substrats wirkende Zugkraft und mindestens eine entgegen der Zugkraft am Umfang der ersten Substrathalterung wirkende Gegenkraft zur Erzeugung von Lösemomenten entlang einer Lösefront anlegbar sind. Hierdurch kann die Gesamtbelastung, insbesondere beim Beginn des Ablösens, reduziert werden. Auf diese Weise wird eine noch stärkere Schonung des ersten und des zweiten Substrats bewirkt. Es ist dabei insbesondere vorgesehen, dass die Zugkräfte sich, insbesondere durch gleichmäßige Aufbringung von Zugkräften am Umfang der zweiten Substrathalterung, zu einer resultierenden Zugkraft im Zentrum der zweiten Substrathalterung summieren, während sich die Gegenkraft oder die Gegenkräfte zu einer resultierenden Gegenkraft an einem Rand der ersten Substrathalterung sowie entsprechenden Lösemomenten an der wandernden Lösefront summieren. Die erste Substrathalterung wird demnach gegenüber der zweiten Substrathalterung gekippt.

Zur noch stärkeren Schonung des zweiten Substrats, insbesondere bei sehr empfindlichen oder sehr teuren zweiten Substraten, ist es erfindungsgemäß vorgesehen, die zweite Substrathalterung als starre, insbesondere das zweite Substrat vollflächig aufnehmende, Aufnahme auszubilden.

Erfindungsgemäß ist vorgesehen, die erste und/oder zweite Substrathalterung als, insbesondere offener, Ring mit verstellbarem Innendurchmesser Dᵢ auszubilden. Durch die Ringform lässt sich die Biegesteifigkeit auch durch die Ringgeometrie, insbesondere die Ringbreite B zum Ringdurchmesser Dₐ und/oder zur Höhe H des Rings optimal auf das erste Substrat einstellen. Die Ringform bewirkt weiterhin, dass im Bereich der Ringöffnung eine stärkere Bewegungsfreiheit des ersten Substrats zugelassen wird, so dass ein Zusammenwirken der Biegesteifigkeit der Substrathalterung und der Biegesteifigkeit des ersten Substrats erreicht wird. Dabei ist die Biegesteifigkeit der ersten Substrathalterung insbesondere mindestens gleich oder höher als die Biegesteifigkeit des ersten Substrats. Es ist vorteilhaft, die zweite Substrathalterung unterschiedlich von der ersten Substrathalterung auszubilden, insbesondere nicht als offener Ring, sondern bevorzugt als vollflächige Subtrataufnahme, insbesondere als Chuck.

Die Biegesteifigkeit der ersten Substrathalterung ist mit Vorteil erfindungsgemäß derart gewählt, dass diese in einem Bereich zwischen 1/20 bis 20 mal, insbesondere zwischen 1/10 bis 10 mal, vorzugsweise zwischen 1/5 bis 5 mal, noch bevorzugter zwischen ½ bis 2 mal, der Biegesteifigkeit des ersten Substrats liegt. Als erstes Substrat kommt insbesondere ein Wafer aus Silizium mit einer Dicke d zwischen 500µm und 750µm, vorzugsweise von 600µm, in Frage. Dieser kann einen Durchmesser Dₜ von 200 mm oder 300 mm aufweisen.

Dabei ist es von besonderem Vorteil, insbesondere über den gesamten Ringumfang verlaufende, Haltemittel, insbesondere in Form einer zurückspringenden Umfangsschulter, vorzusehen. Somit kann mit einer einfachen geometrischen Form, die kostengünstig herstellbar ist, sowohl die Lösekraft auf das erste Substrat, insbesondere am gesamten Umfang des ersten Substrats, aufgebracht werden und die besonders kritische Initiierung der Lösefront beim Beginn des Ablösens an eine oder mehrere Stellen am Umfang des Trägersubstarts konzentriert werden.

In Weiterbildung ist es erfindungsgemäß vorgesehen, dass die Substrathalterung das erste Substrat im Wesentlichen vollständig, insbesondere mindestens zu 98% des Umfangs, vorzugsweise mindestens zu 99%, noch bevorzugter zu mindestens 99,5%, seitlich umschließend ausgebildet ist. Hierdurch wird das erste Substrat quasi vollumfänglich gestützt. Die Substrathalterung ist erfindungsgemäß als, vorzugsweise mindestens zu 98% des Umfangs, noch bevorzugter mindestens zu 99%, noch bevorzugter zu mindestens 99,5%, umfangsgeschlossener Ring ausgebildet.

Der Ring kann auch aus Einzelsegmenten zusammengesetzt sein.

Gemäß einer vorteilhaften Ausführungsform weisen die Lösemittel translatorische Antriebsmittel zur Bewirkung einer Translationsbewegung mindestens eines Umfangsabschnitts der Substrathalterung zur Aufnahme des ersten Substrats in Löserichtung L auf.

Als eigenständige Erfindung ist ein Verfahren zum Lösen eines ersten Substrats von einem zweiten Substrat in einer Löserichtung L mit folgenden Schritten, insbesondere folgendem Ablauf, vorgesehen:
- Halterung des zweiten Substrats mit einer zweiten Substrathalterung und Halterung des ersten Substrats mit einer in Löserichtung L biegsamen, ersten Substrathalterung und
- Ablösen des ersten Substrats vom zweiten Substrat unter Biegung des ersten Substrats.

Weiterhin ist erfindungsgemäß eine Verwendung einer biegsamen ersten Substrathalterung zur Halterung eines ersten Substrats beim Ablösen des ersten Substrats von einem zweiten Substrat vorgesehen. Insbesondere wird als zweite Substrathalterung auch eine biegsame Substrathalterung verwendet.

In vorteilhafter Ausführungsform der Erfindung ist vorgesehen, dass das Ablösen bei einer Temperatur < 200°C, vorzugsweise < 100°C, noch bevorzugter < 50°C, idealerweise bei Umgebungstemperatur, insbesondere ohne vollflächige Aufheizmittel, erfolgt. Erfindungsgemäß erfolgt das Ablösen insbesondere bei einer Temperatur unterhalb der Temperatur, bei der eine permanente Verbindung des ersten und/oder zweiten Substrats erfolgt, insbesondere bei einer Rekristallisationstemperatur des Substrats.

Das erfindungsgemäße Verfahren wird dadurch weitergebildet, dass das Ablösen des ersten Substrats nach einem Bonden mittels Van-der-Waals-Kräften und vor einem Erhitzen des ersten und zweiten Substrats auf eine Temperatur erfolgt, oberhalb der eine permanente Verbindung des ersten und/oder zweiten Substrats erfolgt.

Vorteilhaft wäre eine Verbindungsart, die so ausgebildet ist, dass ein Lösen bis zu einer Bondkraft von mehr als 0,2 J/m², vorzugsweise mehr als 0,4 J/m², mit größerem Vorzug mehr als 0,8 J/m² erfolgt. Die Bruchfestigkeit eines SiO₂ Bulks beträgt dabei ca. 2,0 - 2,5 J/m².

Erfindungsgemäß ist es denkbar, das Ablösen, insbesondere an der Lösefront, zu beschleunigen, indem lokal auf die Lösefront durch die Lösemittel eingewirkt wird, insbesondere durch Trennungsmittel. Die Trennungsmittel können mechanisches Trennen und/oder lokales Aufheizen, vorzugsweise einen gerichteten Heizluftstrom umfassen. Konkret können ein Trennkeil, eine Trennklinge, ein Trenndraht oder ein auf die Lösefront gerichteter, vorzugsweise warmer, Druckluftstrahl einzeln oder kombiniert vorgesehen sein. In der Fachwelt werden diese und ähnliche Techniken verwendet, um ein sogenanntes "Cleaving" durchzuführen. Dabei handelt es sich meist um das Spalten eines Substrats, meist eines sehr spröden Substrats wie Si oder Ge, entlang eines geschwächten Bereichs, um dünne und ultradünne Schichten zu übertragen. Die erfindungsgemäße Ausführungsform ist ebenfalls für derartige Cleaving Prozesse verwendbar.

Unter einem Trennkeil versteht man ein Werkzeug mit vorzugsweise v-förmigem Profil. Unter einer Trennklinge versteht man ein Werkzeug mit einer extrem scharfen Kante. Der Trenndraht ist ein sehr dünner, mit Vorzug hochfester Draht, welcher durch eine entsprechende Apparatur im gespannten Zustand in der Ebene der Zwischenschicht auf sie zu verschoben wird. Der Trenndraht ist insbesondere als Heizdraht, also beheizbar ausgebildet.

Erfindungsgemäß ist auch eine Ausführungsform denkbar, bei der die Lösefront quasi spiralförmig während des Lösens entlang des Umfangs des zweiten Substrats nach innen zum Zentrum verläuft. Dies wird erreicht, indem die am Umfang wirkenden Lösekräfte am Umfang umlaufend gesteigert werden.

Als eigenständige Erfindung ist die Verwendung der Trägerhalterung oder der Vorrichtung oder des Verfahrens zum Ablösen eines mit einem zweiten Substrat, insbesondere ausschließlich, mittels Van-der-Waals-Kräften verbundenen ersten Substrats von dem zweiten Substrat. Dies gilt insbesondere für Fusion gebondete Substrate, die noch nicht einem Annealing unterzogen wurden oder deren Bondkraft noch unter 1,0 J/m² beträgt.

Als erstes und/oder zweites Substrat werden, insbesondere bearbeitete, SiO₂-Wafer verwendet.

Somit ist erfindungsgemäß, insbesondere bei Vorsehen eines Überprüfungsschrittes (Verfahren) oder einer Überprüfungseinrichtung (Vorrichtung), die Trennung eines bereits zumindest teilweise gebondeten Substratpaares denkbar. Soweit die Überprüfung des gebondeten Substratpaares (erstes und zweites Substrat) ergibt, dass Qualitätskriterien nicht oder nicht vollständig den vorgegebenen Kriterien entsprechend erfüllt werden, wird ein erfindungsgemäßes Ablösen bewirkt. Unter Qualitätskriterien versteht man vorwiegend aber nicht ausschließlich physikalische und/oder chemische Bondstärke, Justiergenauigkeit der beiden Substrate zueinander oder ein vollflächiges Bondinterface, also ein Bondinterface welches keine nicht gebondeten Stellen besitzt. Allerdings kann jede andere Art von entdeckten und/oder aufgetretenen Zuständen oder Vorgängen, die hier nicht explizit erwähnt werden aber auf alle Fälle unerwünscht sind, zu einem erfindungsgemäßen Ablösen zwingen. Das erste und/oder das zweite Substrat können so einer Überarbeitung zugeführt werden und neu - gegebenenfalls auch in neuer Kombination eines ersten und zweiten Substrats - gebondet werden. Somit wird ein Rework und/oder Refurbishing bis zu einem späteren Zeitpunkt des Herstellungsprozesses erfindungsgemäß ermöglicht. Mit dem Rework und/oder Refurbishing wird ein erneutes Bonden der Substrate ohne die entsprechenden Fehler ermöglicht und so die Ausbeute im Fertigungsprozess drastisch erhöht.

Für die erfindungsgemäße Vorrichtung und das erfindungsgemäße Verfahren sowie die erfindungsgemäße Verwendung gelten die beschriebenen Merkmale analog.

Weitere Vorteile, Merkmale und Einzelheiten der Erfindung ergeben sich aus der Beschreibung bevorzugter Ausführungsbeispiele sowie anhand der Zeichnungen. Diese zeigen in:
- Figur 1: eine Aufsicht auf eine erfindungsgemäße Substrathalterung mit einer Schnittlinie A-A,
- Figur 2: eine Querschnittsansicht der Substrathalterung gemäß Schnittlinie A-A aus Figur 1,
- Figur 3: eine Ansicht der Substrathalterung gemäß Figur 1 von unten,
- Figur 4: eine Detailansicht des Details E aus Figur 2,

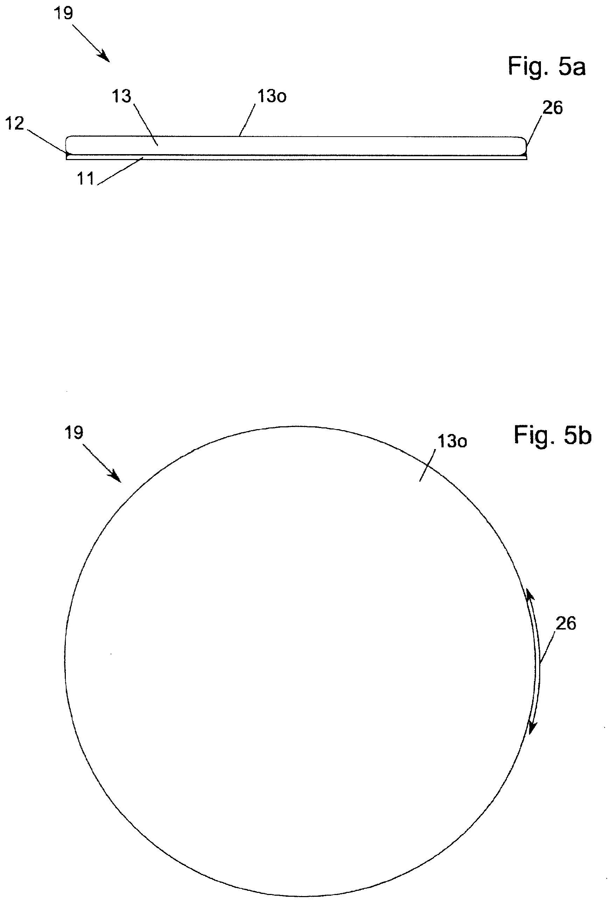

- Figur 5a: eine Seitenansicht eines Stacks aus einem ersten Substrat, der Verbindungsschicht und einem zweiten Substrat,
- Figur 5b: eine Aufsicht eines Stacks aus dem ersten Substrat, der Verbindungsschicht und dem zweiten Substrat,
- Figur 6: eine Detailansicht analog Figur 4 mit einer ersten Ausführungsform der Substrathalterung,
- Figur 7: eine Detailansicht analog Figur 4 mit einer zweiten Ausführungsform der Substrathalterung,
- Figur 8: ein auf einem Filmrahmen festgelegter Stack,
- Figuren 9a - 9d: eine Vorrichtung gemäß einer ersten Ausführungsform mit vier Verfahrensschritten und
- Figuren 10a - 10d: eine zweite Ausführungsform der erfindungsgemäßen Vorrichtung mit vier erfindungsgemäßen Verfahrensschritten.

In den Figuren sind gleiche oder gleichwirkende Bauteile mit den gleichen Bezugszeichen gekennzeichnet.

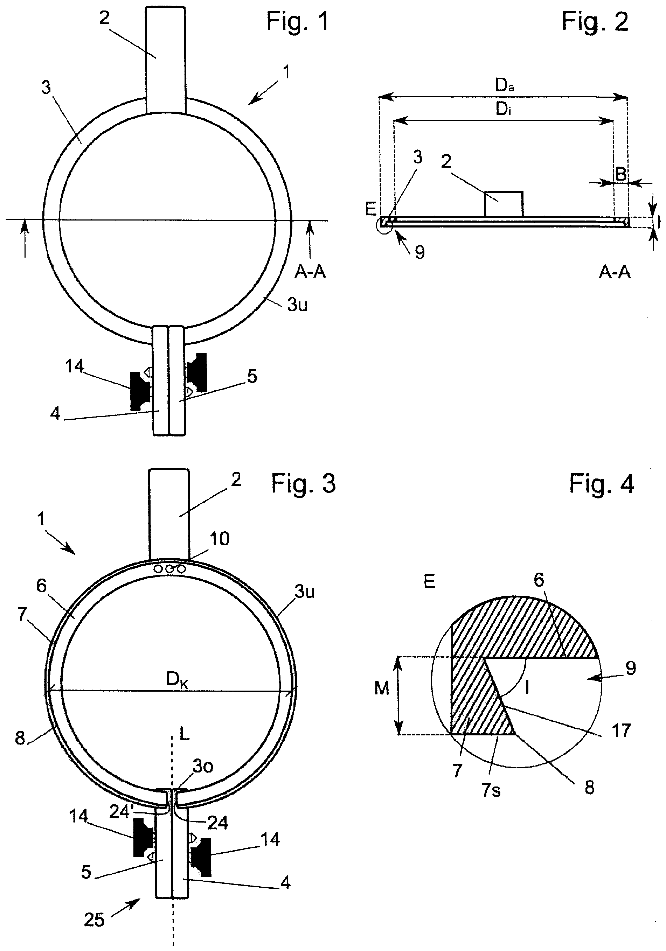

Figur 1 zeigt eine halbautomatisch einsetzbare Substrathalterung 1, bei der die Aufnahme eines ersten Substrats 13 (hier: stabileres Trägersubstrat) durch die Substrathalterung 1 manuell erfolgt. Die Substrathalterung 1 dient zum Ablösen des ersten Substrats 13 von einem durch eine Verbindungsschicht 12 mit dem ersten Substrat 13 verbundenen zweiten Substrat 11 (hier: Produktsubstrat).

Die Substrathalterung 1 besteht aus einem an einem Umfangsabschnitt 26 angeordneten Haltegriff 2 und einem gegenüberliegend zum Haltegriff 2 geöffneten Ring 3. An der Öffnung 3o des Rings 3 sind jeweils an den sich gegenüberliegenden Enden 24, 24' des Rings 3 Abstandsmittel 25 zur Einstellung eines Abstands A zwischen den Enden 24, 24' vorgesehen. Durch die Einstellung des Abstands A sind ein innerer Durchmesser Dᵢ und ein äußerer Durchmesser Dₐ des Rings 3 einstellbar. Die Abstandsmittel 25 bestehen im vorliegenden Ausführungsbeispiel aus Hebeln 4, 5, wobei der Hebel 4 an dem Ende 24 und der Hebel 5 an dem Ende 24' eingebracht sind. Die Hebel 4, 5 sind von Stellelementen 14 durchsetzt, die hier manuell bedienbar sind. Eine automatische Umsetzung der vorbeschriebenen manuellen Kinematik ist erfindungsgemäß denkbar.

Die Befestigung des Haltegriffs 2 am Ring 3 erfolgt durch Fixierelemente 10, insbesondere Schrauben. Das Material des Rings 3 ist erfindungsgemäß bei vorgegebener Geometrie (Ringhöhe H, Ringbreite B, Außendurchmesser Dₐ, Innendurchmesser Dᵢ) so zu wählen, dass der Ring 3 sich durch die Abstandsmittel 25 elastisch verbiegen lässt, und zwar entgegen seiner durch die Biegesteifigkeit bewirkten Kraft.

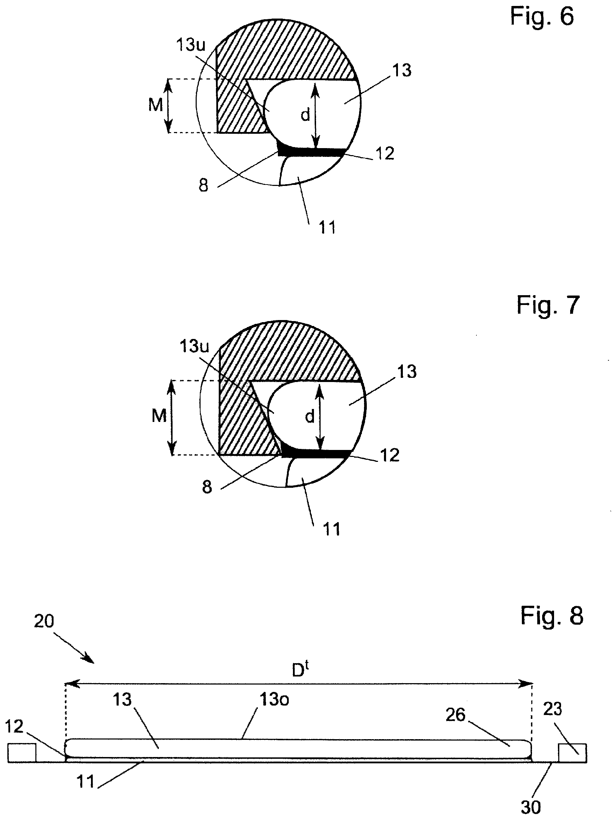

Der Ring 3 weist eine Umfangsschulter 7 auf, die von einem Ringabsatz 6 absteht und eine Stufe 9 bildet. Die Stufe 9 verläuft z-förmig mit einem zur Ringmitte gerichteten Innenwinkel 45° < I < 90°, insbesondere < 80°, vorzugsweise < 70° und bildet dadurch eine, insbesondere umlaufende, Wandschräge 17, die an einer spitzen Innenkante 8 endet. Die Innenkante 8 ist gleichzeitig Bestandteil einer parallel zum Ringabsatz 6 verlaufenden Stirnfläche 7s der Umfangsschulter 7. Die Stirnfläche 7s ist äquidistant zu dem Ringabsatz 6 mit einem Abstand M. Der Abstand M ist erfindungsgemäß so gewählt, dass er maximal geringfügig größer, insbesondere maximal um die Dicke der Verbindungsschicht 12 größer, als eine Dicke d des ersten Substrats 13 ist (siehe Figur 7). Vorzugsweise ist der Abstand M wie in Figur 6 so gewählt, dass er kleiner als die Dicke d des ersten Substrats 13 ist. Vorzugsweise ist der Abstand M mindestens halb so groß wie die Dicke d des ersten Substrats 13.

Durch die Abstandsmittel 25 lässt sich ein durch die Innenkante 8 gebildeter, zwischen dem Innendurchmesser Dᵢ und dem Außendurchmesser Dₐ liegender, Durchmesser Dₖ zur Aufnahme des ersten Substrats 13 vergrößern, bis das erste Substrat 13 durch eine durch die Innenkante 8 gebildete Öffnung (Durchmesser Dₖ) bis zum Ringabsatz 6 einsetzbar ist. Anschließend wird durch die Abstandsmittel 25 der Durchmesser Dₖ wieder verringert, bis eine Umfangskante 13u des ersten Substrats 13 an der Schräge 17 der Umfangsschulter 7 anliegt und durch diese fixiert wird. Somit ist das erste Substrat 13 von der biegsamen Substrathalterung 1 gehalten. Die Halterung erfolgt quasi durch Klemmung und/oder Formschluss. Bei Klemmung des ersten Substrats 13 an der Schräge 17 können Kraftmessmittel zur Steuerung der Einklemmung vorgesehen sein, insbesondere an den Stellmitteln 14.

Das zweite Substrat 11 (hier: Produktsubstrat) ist nur über die Verbindungsschicht 12 an der Substrathalterung 1 befestigt. Ein direkter Kontakt zwischen der Substrathalterung 1 und dem zweiten Substrat 11 ist nicht vorgesehen. Bei Vermeidung eines Kontakts zwischen der Substrathalterung 1 und dem zweiten Substrat 11 wird das zweite Substrat 11 maximal geschont und eine Kontamination oder Beschädigung praktisch ausgeschlossen.

Das zweite Substrat 11 bildet mit der Verbindungsschicht 12 und dem ersten Substrat 13 einen Stack 19 (Erstes Substrat - zweites Substrat - Verbund). Ebenso ist die vorliegende Erfindung geeignet für einen Verbund aus erstem Substrat und zweitem Substrat ohne dazwischenliegende Verbindungsschicht, insbesondere bei sogenannten Pre-Bonds, bei welchen die Wafer insbesondere mittels Van-der-Waals-Kräften aneinander haften.

Die spitze Innenkante 8 dient bei der Fixierung des Stacks 19 an der Substrathalterung 1 in der in Figur 7 gezeigten Ausführungsform gleichzeitig als Trennmittel beziehungsweise zur Initiierung des Ablösens, indem die Spitze der Innenkante 8 an der Umfangskante der Verbindungsschicht 12 in die Verbindungsschicht 12 eindringt.

Bei einer Verwendung bei Substratpaaren ohne Verbindungsschicht 12, insbesondere bei fusiongebondeten Wafern, ist die hier beschriebene Verbindungsschicht 12 die Grenzfläche (an der die Van-der-Waals-Kräfte wirken) zwischen dem Substratpaar.

Die Substrathalterung 1 umschließt das erste Substrat 13 praktisch vollständig, mit Ausnahme der Ringöffnung 3o.

Figur 8 zeigt den Stack 19 auf einem Filmrahmen 23, wobei das zweite Substrat 11 mit einer mit dem Filmrahmen 23 verbundenen Folie 21 verbunden ist. Der Stack 19, der Filmrahmen 23 und der Folie 21 einen Filmrahmenverbund 20.

Mittels des Haltegriffs 2 und durch Fixierung des zweiten Substrats 11 oder des Filmrahmens 23 ist das erste Substrat 13 von dem zweiten Substrat 11 abziehbar. Die Zugkraft wird dabei durch die einseitige Anordnung des Haltegriffs 2 seitlich an dem ersten Substrat 13, also an dem Umfangsabschnitt 26, aufgebracht. Initiiert durch das Eindringen der Innenkante 8 in die Verbindungsschicht 12 wird das erste Substrat 13 unter Verformung des ersten Substrats 13 und des Rings 3 (entgegen deren durch die Biegesteifigkeit erzeugten Kraft) ausgehend von dem Umfangsabschnitt 26 zur gegenüberliegenden Seite langsam abgelöst. Dabei wandert eine Lösefront von dem Umfangsabschnitt 26 bis zur gegenüberliegenden Seite des ersten Substrats 13 durch die Verbindungsschicht 12. Entlang der Lösefront wirken demnach je nach Abstand der Lösefront vom Haltegriff 2 und der am Haltegriff 2 angelegten Lösekraft definierte Drehmomente.

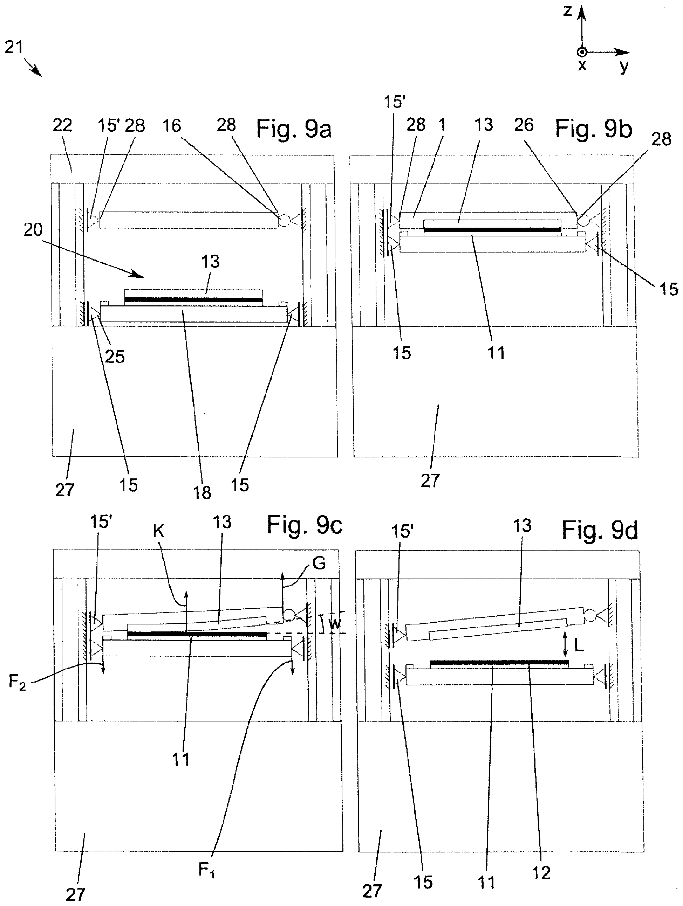

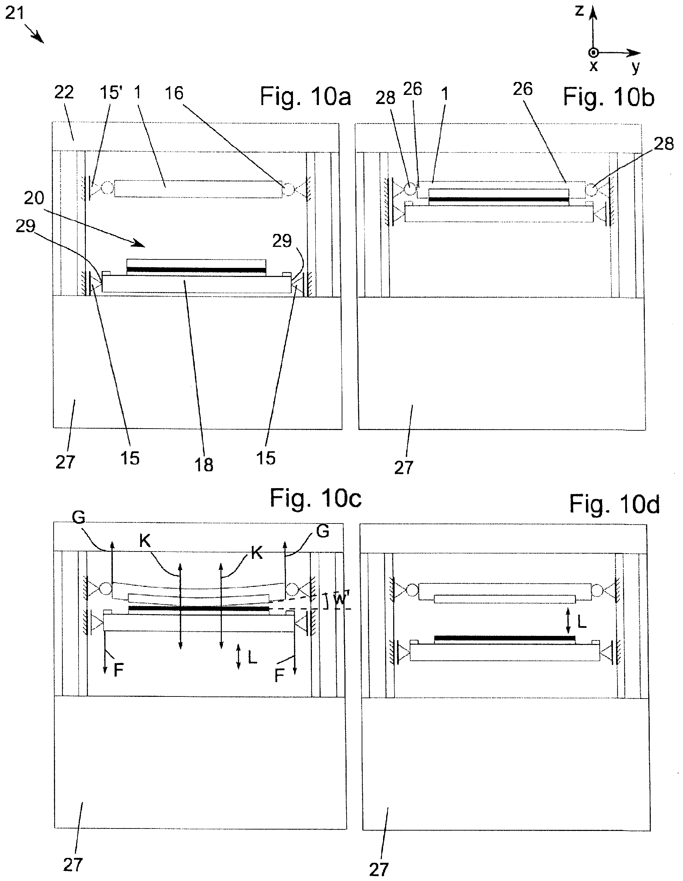

In automatisierter Form ist dies in den Figuren 9a bis 9d in einer ersten Ausführungsform und in den Figuren 10a bis 10d in einer zweiten Ausführungsform gezeigt, die nachfolgend näher beschrieben werden.

Den beiden Ausführungsformen gemein ist die Verwendung der oben beschriebenen (ersten) Substrathalterung 1 zur Halterung des ersten Substrats 13 in einer zur Automatisierung geeigneten Form.

Ein wesentlicher Erfindungsaspekt besteht darin, beim Beginn des Ablösens, also bei der Initiierung des Ablösens, eine besonders schonende Behandlung vorzusehen, insbesondere durch Implementierung einer mechanischen Anlösung der Verbindungsschicht am Umfang beziehungsweise an deren Rand.

In den Figuren 9 und 10 sind jeweils eine Basis 27 und ein darauf aufbauendes Gestell 22 zur Vorsehung einer stabilen Grundkonstruktion und Befestigung weiterer, unten beschriebener Bauteile der erfindungsgemäßen Vorrichtung gezeigt. An dem Gestell 22 und/oder der Basis 27, insbesondere zwischen einem Deckel 22d des Gestells 22 und einem durch die Basis 27 gebildeten Boden 27b, sind Antriebsmittel 15' zur translatorischen Bewegung (insbesondere angetrieben) der (ersten) Substrathalterung 1 beziehungsweise von Umfangsabschnitten der Substrathalterung 1 sowie Antriebsmittel 15 zur translatorischen Bewegung (insbesondere angetrieben) einer den Stack 19 oder den Filmrahmenverbund 20 aufnehmenden (zweiten) Substrathalterung 18 (Aufnahme) vorgesehen. Die Antriebsmittel 15' können einen Freilauf in Translationsrichtung aufweisen, insbesondere gebildet durch ein Loslager.

Die Substrathalterung 18 ist bei beiden Ausführungsformen gemäß Figur 9 und Figur 10 in einer Löserichtung L, also in der Zeichnungsebene nach oben und/oder unten translatorisch bewegbar. Die Antriebsmittel 15 zum Antreiben der Substrathalterung 18 können dabei insbesondere synchron bewegt werden, vorzugsweise angetrieben durch von einer zentralen Steuereinrichtung gesteuerte Motoren, insbesondere Schrittmotoren.

In der Ausführungsform gemäß Figur 9 ist für die Substrathalterung 1 nur ein Antriebsmittel 15' an der zum Umfangsabschnitt 26 gegenüberliegenden Seite der Substrathalterung 1 vorgesehen, während am Umfangsabschnitt 26 ein Gelenklager 16 vorgesehen ist, so dass die Substrathalterung 1 um das Gelenklager 16 schwenkbar ist, jedoch in Löserichtung L fixiert ist. Somit ergibt sich folgender Verfahrensablauf:

In dem in Figur 9a gezeigten Verfahrensschritt wird die für den Filmrahmenverbund 20, insbesondere das erste Substrat 13, passende Substrathalterung 1 an dem oberen Antriebsmittel 15' und dem Gelenklager 16 angebracht. Gleichzeitig, vorher oder anschließend wird der Filmrahmenverbund 20 auf die Substrathalterung 18 fixiert, insbesondere durch Vakuumbeaufschlagung. Die Substrathalterung 18 ist durch die Antriebsmittel 15 in Löserichtung L bewegbar.

Erfindungsgemäß ist des dabei alternativ denkbar, dass am Umfang der Substrathalterung 1 mehrere, insbesondere zwei, Antriebsmittel 15' an einer Seite und mehrere, insbesondere zwei, Gelenklager 16 an der gegenüberliegenden Seite, vorgesehen sind.

Die Substrathalterung 1 ist jeweils durch am Ringumfang 3u angeordnete Haltemittel 28 an dem Antriebsmittel 15' und dem Gelenklager 16 fixierbar. Die Substrathalterung 18 ist durch Haltemittel 29 an den Antriebsmitteln 15 fixierbar.

Anschließend wird die Substrathalterung 18 in die in Figur 9b gezeigte Position (also in Löserichtung L zu der Substrathalterung 1 hin) verfahren, indem die Antriebsmittel 15 eine synchrone Translationsbewegung der Substrathalterung 18 ausführen, bis das erste Substrat 13 mit seiner Oberseite 13o an dem Ringabsatz 6 anliegt. Die Steuerung kann über die zentrale Steuereinrichtung erfolgen, wobei die Erkennung des Auftreffens des ersten Substrats 13 auf den Ringabsatz 6 durch, insbesondere in die Substrataufnahme 18 integrierte, Kraftmessmittel erfolgt. Vorzugsweise sind am Umfang der Substrathalterung 18 eine Anzahl n Kraftmessdosen in einem Winkelabstand von 360°/n verteilt angeordnet.

Damit das erste Substrat 13 in der Substrathalterung 1 aufnehmbar ist, muss vorher der Durchmesser Dₖ an der Innenkante 8 des Rings 3 entsprechend angepasst werden, damit das erste Substrat 13 mit seiner Außenkontur (insbesondere kreisförmig mit einem Durchmesser Dₜ) in die Substrathalterung 1 aufnehmbar ist. Der Innendurchmesser Dᵢ ist bei der Aufnahme des ersten Substrats 13 kleiner als der Durchmesser Dₜ des ersten Substrats 13, damit das erste Substrat 13 nicht durchrutscht. Sobald die in Figur 9b gezeigte Position erreicht ist, kann der Innendurchmesser Dᵢ verringert werden, bis das erste Substrat 13 in der Substrathalterung 1 fixiert ist (siehe Figuren 6 und 7), also an der Wandschräge 17 anliegt.

Sobald die in Figur 9b gezeigte Position erreicht ist, wird das obere, fixierbare Antriebsmittel 15' gelöst, so dass dieses einen Freiheitsgrad in Löserichtung L hat und die an dem Antriebsmittel 15' befestigte Seite der Substrathalterung 1 in Löserichtung L freibeweglich ist. In dieser Ausführungsform ist das Antriebmittel 15' antriebslos ausgebildet. Erfindungsgemäß denkbar ist aber auch hier eine Steuerung der Bewegung durch die zentrale Steuereinrichtung, so dass das Antriebsmittel 15' nicht passiv (wie in der bevorzugten Ausführungsform), sondern aktiv ausgebildet ist.

Anschließend wird an den beiden gegenüberliegend an der Substrathalterung 18 vorgesehenen Antriebsmitteln 15 auf die Substrathalterung 18 jeweils eine von der Substrathalterung 1 weg gerichtete Antriebskraft F₁ (Zugkraft) und eine, insbesondere mit der Antriebskraft F₁ identische, Antriebskraft F₂ (Zugkraft), insbesondere synchron, zum Ablösen des an der Substrathalterung 1 fixierten Ersten Substrats 13 von dem zweiten Substrat 11 angelegt.

Entgegen der Antriebskräfte F₁ und F₂ und insbesondere parallel zu diesen wirkend liegt an dem Gelenklager 16 eine Gegenkraft G (oder mehrere Gegenkräfte G, falls mehrere Gelenklager 16 vorgesehen sind) an.

Hierdurch wird der von der Innenkante 8 initiierte Ablösevorgang fortgesetzt, wobei an der sich vom Gelenklager 16 bis zur gegenüberliegenden Seite der Substrathalterung 1 eine Lösefront unter zunehmender Biegung der Substrathalterung 1 und des ersten Substrats 13 verläuft. Entlang der Lösefront wirken im Gleichgewicht mit den Antriebskräften F₁ und F₂ sowie der (durch die Verbindungskraft der Verbindungsschicht 12 bewirkte) Gegenkraft G Drehmomente als infinitesimal entlang der Lösefront verteilte Lösemomente K₁ bis Kₙ.

In der in Figur 9c gezeigten Position ist das erste Substrat 13 zu mehr als der Hälfte abgelöst, wobei die Ablösung erfolgt, indem sich sowohl das erste Substrat 13 als auch die Substrathalterung 1 verformen (entgegen der Biegefestigkeit der Substrathalterung 1 und des ersten Substrats 13).

In der in Figur 9d gezeigten Position ist das erste Substrat 13 vollständig von dem zweiten Substrat 11 abgelöst. Die Verbindungsschicht 12 haftet in der Darstellung an dem zweiten Substrat 11, kann aber auch teilweise oder vollständig an dem ersten Substrat 13 anhaften.

Während des Ablösens verbiegt sich die Substrathalterung 1 und das erste Substrat 13 um einen (mittleren, insbesondere gemessen bei halber Ablösung des ersten Substrats 13 vom zweiten Substrat 11) Biegewinkel 1° < W < 45°, insbesondere W < 35° hier etwa 6°.

In der zweiten, erfindungsgemäßen Ausführungsform gemäß Figur 10a bis Figur 10d ist statt dem Antriebsmittel 15' ein Gelenklager 16 an der Substrathalterung 1 vorgesehen, so dass die Substrathalterung 1 an dem Umfangsabschnitten 26 und einem gegenüberliegenden Umfangsabschnitt 26' (also wo die Gelenklager 16 an Haltemitteln 28 der Substrathalterung 1 angebracht sind) in Löserichtung L fix sind (Erfindungsgemäß können mehrere Gelenklager 16 am Umfang der Substrathalterung 1 vorgesehen sein). In Abschnitten zwischen den Umfangsabschnitten 26 ist die Substrathalterung 1 im Rahmen ihrer Biegsamkeit entgegen der Biegesteifigkeit beweglich. Somit ergibt sich bei Anlegen der Antriebskräfte im Verfahrensschritt gemäß 10c eine im Wesentlichen (gewellt) konzentrisch vom Umfang der Verbindungsschicht 12 verlaufende Lösefront zur Mitte der Verbindungsschicht 12. Dabei spielt die Initiierung durch die Innenkante 8 der Substrathalterung eine wesentliche Rolle zur Überwindung der anfänglichen Verbindungskraft der Verbindungsschicht 12.

Die Lösemomente K₁ bis Kₙ wirken bei der Ausführungsform gemäß Figur 10a bis 10d beim Fortschreiten der Lösefront jeweils überwiegend an einem (gewellten) kreisförmigen Abschnitt entlang der Lösefront. Während der Biegungswinkel W gemäß Figur 9c zum Gelenklager gegenüberliegenden Seitenrand gemessen wird, wird der Biegungswinkel W' wegen der von allen Seiten am Umfang wirkenden Lösekraft K vom Zentrum des ersten Substrats 13 zum Rand gemessen, wobei der Biegungswinkel W' in diesem Fall wegen der geringeren Strecke entsprechend kleiner ist, soweit das Material der Substrathalterung 1 und des ersten Substrats 2 sowie deren Abmessungen ansonsten identisch sind. Durch Reduzierung der Ringbreite B und/oder der Ringhöhe H kann die Biegesteifigkeit des Rings 3 reduziert werden, so dass sich der Biegungswinkel W' erhöhen würde.

### Bezugszeichenliste

- 1: Substrathalterung
- 2: Haltegriff
- 3: Ring
- 3o: Öffnung
- 3u: Ringumfang
- 4: Hebel
- 5: Hebel
- 6: Ringabsatz
- 7: Umfangsschulter
- 7s: Stirnfläche
- 8: Innenkante
- 9: Stufe
- 10: Fixiermittel
- 11: Zweites Substrat
- 12: Verbindungsschicht
- 13: Erstes Substrat
- 13o: Oberseite
- 13u: Umfangskante
- 14: Stellelemente
- 15, 15': Antriebsmittel
- 16: Gelenklager
- 17: Schräge
- 18: Substrathalterung
- 19: Stack
- 20: Filmrahmenverbund
- 21: Folie
- 22: Gestell
- 22d: Deckel
- 23: Filmrahmen
- 24, 24': Enden
- 25: Abstandsmittel
- 26: Umfangsabschnitt
- 27: Basis
- 27b: Boden
- 28: Haltemittel
- 29: Haltemittel
- A: Abstand
- B: Ringbreite
- Dᵢ: Innendurchmesser
- Dₐ: Außendurchmesser
- Dₖ: Durchmesser
- H: Ringhöhe
- M: Abstand
- L: Löserichtung
- I: Innenwinkel
- d: Dicke
- F₁ , F₂, Fₙ: Antriebskräfte (Zugkraft)
- G: Gegenkraft
- K₁, K₂, Kₙ: Lösemomente
- W, W': Biegungswinkel

## Patentansprüche

1. Verfahren zum Lösen eines mit einem zweiten Substrat (11) mittels Fusion-Bond verbundenen ersten Substrats (13) von dem zweiten Substrat (11) in einer Löserichtung (L), wobei die Substrate noch nicht einem Annealing unterzogen wurden, mit folgenden Schritten:
- Halterung des zweiten Substrats (11) mit einer Substrathalterung und Halterung des ersten Substrats (13) mit einer in Löserichtung (L) biegsamen Substrathalterung (1) und
- Ablösen des ersten Substrats (13) vom zweiten Substrat (11) unter Biegung des ersten Substrats (13), **dadurch gekennzeichnet, dass** die erste Substrathalterung (1) als in der Löserichtung (L) biegsamer Ring (3) mit verstellbarem Durchmesser (Dₖ) ausgebildet ist, wobei die Löserichtung (L) orthogonal zu einer Bondebene steht.

2. Verfahren nach Anspruch 1, bei dem das Ablösen des ersten Substrats nach einem Bonden mittels Van-der-Waals-Kräften und vor einem Erhitzen des ersten und zweiten Substrats auf eine Temperatur oberhalb einer Rekristallisationstemperatur des ersten und/oder zweiten Substrats erfolgt.

3. Verfahren nach Anspruch 1 oder 2, bei dem das Ablösen bei einer Bondkraft zwischen dem ersten und zweiten Substrat von mehr als 0,2 J/m² , vorzugsweise mehr als 0,4 J/m² , noch bevorzugter mehr als 0,8 J/m² erfolgt.

4. Verfahren nach einem der Ansprüche 1 bis 3, bei dem vor dem Lösen ein Überprüfungsschritt zur Überprüfung des gebondeten Substratpaars erfolgt, ob Qualitätskriterien nicht oder nicht vollständig den vorgegebenen Kriterien entsprechend erfüllt werden.

5. Verwendung einer in einer Löserichtung (L) biegsamen Substrathalterung zum Ablösen eines mit einem zweiten Substrat (11) verbundenen ersten Substrats (13) von dem zweiten Substrat (11) für Fusion-gebondete Substrate, die noch nicht einem Annealing unterzogen wurden, **dadurch gekennzeichnet, dass** die Substrathalterung als Ring (3) mit verstellbarem Durchmesser (Dₖ) ausgebildet ist, wobei die Löserichtung (L) orthogonal zu einer Bondebene steht.

## Claims

1. A method for detaching a first substrate (13) which is connected to a second substrate (11) by means of fusion bonding from the second substrate (11) in one detachment direction (L), wherein the substrates have not yet undergone annealing, with the following steps:
- holding the second substrate (11) with a substrate mount and
- holding the first substrate (13) with a substrate mount (1) which is flexible in the detachment direction (L) and
- debonding of the first substrate (13) from the second substrate (11) as the first second substrate (13) bends,
**characterized in that**
the first substrate mount (1) is made as a ring (3) with an adjustable diameter (Dₖ) and is flexible in the detachment direction (L), wherein the detachment direction (L) is orthogonal to a bonding plane.

2. The method as claimed in Claim 1, wherein the debonding of the first substrate takes place after a bonding by means of van der Waals forces and before heating of the first and second substrate to a temperature above a recrystallization temperature of the first and/or second substrate.

3. The method as claimed in Claim 1 or 2, wherein debonding takes place at a bond force between the first and second substrate of more than 0.2 J/m², preferably more than 0.4 J/m², still more preferably more than 0.8 J/m².

4. The method as claimed in any one of Claims 1 to 3, wherein a checking step takes place before the detachment to check the bonded substrate pair to establish whether quality criteria are or are not completely met according to the predefined criteria.

5. Use of a substrate mount flexible in a detachment direction (L) for debonding of a first substrate (13) which is connected to a second substrate (1 1) from the second substrate (11) for fusion-bonded substrates which have not yet undergone annealing, **characterized in that** the substrate mount is made as a ring (3) with an adjustable diameter (Dₖ), wherein the detachment direction (L) is orthogonal to a bonding plane.

## Revendications

1. Procédé pour séparer un premier substrat (13), relié à un second substrat (11) par un assemblage par fusion, du second substrat (11) dans un sens de séparation (L), dans lequel les substrats n'ont pas encore été soumis à un recuit, comprenant les étapes suivantes :
- fixation du second substrat (11) avec une fixation de substrat et
- fixation du premier substrat (13) avec une fixation de substrat (1) pouvant être fléchie dans le sens de séparation (L) et
- séparation du premier substrat (13) du second substrat (11) par flexion du premier substrat (13) ,
**caractérisé en ce que**
la première fixation de substrat (1) est conçue en tant que bague (3) à diamètre réglable (Dₖ) pouvant être fléchie dans le sens de séparation (L), dans lequel le sens de séparation (L) est orthogonal à un plan d'assemblage.

2. Procédé selon la revendication 1, dans lequel la séparation du premier substrat est effectuée après un assemblage au moyen de forces de Van der Waals et avant un chauffage du premier et du second substrat à une température au-dessus d'une température de recristallisation du premier et/ou du second substrat.

3. Procédé selon la revendication 1 ou 2, dans lequel la séparation est effectuée à une force d'assemblage entre le premier substrat et le second substrat de plus de 0,2 J/m², de préférence plus de 0,4 J/m², de manière encore plus préférée de 0,8 J/m².

4. Procédé selon l'une des revendications 1 à 3, dans lequel une étape de vérification pour vérifier la paire de substrats assemblés est effectuée avant la séparation pour vérifier si les critères de qualité sont remplis de manière non conforme ou pas complètement conforme aux critères prédéfinis.

5. Utilisation d'une fixation de substrat pouvant être fléchie dans un sens de séparation (L) pour séparer un premier substrat (13) relié à un second substrat (11) du second substrat (11) pour des substrats assemblés par fusion qui n'ont pas encore été soumis à un recuit, **caractérisé en ce que** la fixation de substrat est conçue en tant que bague (3) à diamètre réglable (Dk), dans lequel le sens de séparation (L) est orthogonal à un plan d'assemblage.
